# DEMANDE DE BREVET EUROPEEN

(11) **EP 1 758 173 A1**
(43) Date de publication de la demande: **28.02.2007**
(21) Numéro de dépôt: 05107734.5
(22) Date de dépôt: 23.08.2005
(51) Int. Cl.: H01L 31/0216, H01L 31/103

(54) **Cellule à photodiode à contrôle de la réflectivité de lumière, et procédé de fabrication d'une telle cellule**

(71) Demandeur: EM Microelectronic-Marin SA, 2074 Marin (CH)
(72) Inventeur: Willemin, Michel, 2515, Prêles (CH); Rosenfeld, Daniel, 2017, Boudry (CH)
(74) Mandataire: Vigand, Philippe

(57) **Abrégé**

La cellule à photodiode (1) comprend au moins une région photosensible (3), réalisée dans un substrat semi-conducteur en silicium (2), pour la réception de la lumière, notamment de la lumière cohérente, une couche de passivation et une couche de diélectrique (4). La couche de passivation est composée au moins d'une première couche d'oxyde de silicium (5) et d'une seconde couche de nitrure (6), réalisée sur la région photosensible. La seconde couche de nitrure est réalisée avec une épaisseur dans une marge déterminée de manière à se situer dans une zone à réflectivité de lumière la plus constante possible indépendamment de l'épaisseur de la première couche. Une gravure (7) peut être réalisée sur une portion de la couche de diélectrique (4) ou sur la première couche (5) correspondant à la moitié de la surface de réception de la région photosensible pour moyenner le pourcentage de réflectivité de la lumière à capter par la cellule à photodiode.

## Description

L'invention concerne une cellule à photodiode à contrôle de la réflectivité de lumière, notamment de lumière cohérente. La cellule peut comprendre soit une seule photodiode, soit un réseau matriciel de photodiodes réalisées dans un même substrat semi-conducteur en silicium. La cellule à photodiode comprend au moins une région photosensible réalisée dans le substrat pour la réception de la lumière et une couche de passivation réalisée sur la région photosensible. La couche de passivation est composée au moins d'une première couche d'oxyde de silicium et d'une seconde couche de nitrure.

L'invention concerne également un procédé de fabrication d'une telle cellule à photodiode.

Lorsque de telles cellules à photodiode sont utilisées pour capter de la lumière, notamment de la lumière cohérente d'un laser, dans des applications diverses, un problème de réflectivité du faisceau de lumière arrivant sur la photodiode se pose. Le faisceau de lumière peut être réfléchi en partie sur la seconde couche de nitrure de la couche de passivation, et également sur la première couche d'oxyde de silicium de ladite couche de passivation. De ce fait, le pourcentage de lumière captée par la région photosensible de la photodiode peut être ainsi fortement réduit par phénomène d'interférences.

Dans des applications utilisant uniquement la lumière produite par une diode électroluminescente, la réflectivité de la lumière sur les couches de protection, telles que la couche de passivation est moins importante. Par contre avec une telle diode électroluminescente, le rendement défini par le rapport puissance optique sur puissance électrique est meilleur pour une diode laser. De ce fait, de meilleures performances sont constatées pour des dispositifs utilisant l'émission lumineuse par une diode laser captée par une cellule à photodiode. Ceci permet également de réduire la consommation électrique dans le cas où le dispositif est alimenté par une pile ou un accumulateur de petite taille.

Un autre avantage d'une diode laser fournissant une lumière cohérente est de donner une image plus contrastée que pour une diode électroluminescente. Selon les applications, la présence de "speckles" peut être tirée à profit.

Une des applications possibles d'un tel agencement d'une diode laser et d'une cellule à photodiode réalisée dans un substrat semi-conducteur en silicium peut être une souris sans fil d'ordinateur. La diode laser produit un faisceau laser réfléchi sur une surface de rugosité variable afin d'être capté par une cellule à photodiode. Cette cellule à photodiode peut être un réseau matriciel de photodiodes réalisées dans un même substrat semi-conducteur. De cette manière en fonction de l'intensité captée par chaque photodiode, il est possible d'en déduire une direction de mouvement de la souris ou une certaine vitesse de déplacement.

Comme la lumière produite par la diode laser est une lumière cohérente, une réflexion sur les différentes couches de protection de la cellule à photodiode intervient, ce qui est un inconvénient. Le pourcentage de réflexion peut être important selon l'épaisseur des couches de protection.

L'invention a donc pour but principal de fournir une cellule à photodiode réalisée de manière à contrôler la réflectivité de lumière afin de pallier les inconvénients cités ci-dessus.

A cet effet, l'invention concerne une cellule à photodiode citée ci-devant, qui comprend les caractéristiques mentionnées dans la revendication 1.

Des formes d'exécution avantageuses sont définies dans les revendications dépendantes 2 à 8.

Un avantage de la cellule à photodiode selon l'invention réside dans le fait qu'en contrôlant l'épaisseur de la seconde couche de nitrure de la couche de passivation, il est possible d'obtenir une réflectivité sensiblement constante ou un pourcentage de réflectivité constant. Ce pourcentage de réflectivité constant est indépendant de l'épaisseur de la première couche d'oxyde de silicium de la couche de passivation, ainsi que de l'épaisseur d'une couche de diélectrique entre la région photosensible et la première couche. Le pourcentage de réflexion constant peut être d'une valeur proche de 25%, ce qui est bien inférieur au maxima de réflectivité, qui peut être de l'ordre de 50%.

L'épaisseur de la couche de nitrure doit être contrôlée en fonction du procédé de fabrication utilisé et de la longueur d'onde de la lumière à capter. Cette épaisseur est contrôlée durant le procédé de fabrication de la cellule à photodiode pour chaque plaquette de cellules à photodiode et pour chaque lot de plaquettes.

Avantageusement, la couche de diélectrique ou la première couche de la couche de passivation est gravée par attaque chimique à une première épaisseur sur au moins une première portion de la région photosensible. La couche de diélectrique ou la première couche est à une seconde épaisseur différente de la première épaisseur sur une seconde portion de la région photosensible. L'écart d'épaisseur de la couche de diélectrique ou de la première couche sur les deux portions de la région photosensible est déterminée en fonction de l'écart d'épaisseur de la première couche en oxyde de silicium entre un pourcentage minimal et maximal de réflectivité de lumière.

La dimension de la première portion de la région photosensible peut être égale à la dimension de la seconde portion de la région photosensible. Il peut avantageusement être prévu plusieurs premières portions et plusieurs secondes portions réparties en mosaïque au-dessus de la région photosensible, par exemple sous forme d'un damier. De cette manière, une moyenne du pourcentage de réflectivité de lumière peut être obtenue de la première couche d'oxyde et de la couche de diélectrique, dont l'épaisseur n'est pas contrôlable.

A cet effet, l'invention concerne également un procédé de fabrication d'une cellule à photodiode citée ci-devant, qui comprend les caractéristiques définies dans la revendication 9.

Des étapes particulières du procédé sont définies dans la revendication dépendante 10.

Les buts, avantages et caractéristiques de la cellule à photodiode et de son procédé de fabrication apparaîtront mieux dans la description suivante en regard des dessins sur lesquels :
- la figure 1 représente de manière simplifiée une coupe verticale d'une cellule à photodiode captant une partie d'un faisceau de lumière, dont l'autre partie est réfléchie sur les couches de la couche de passivation et de la couche de diélectrique,
- la figure 2 représente un graphique de la réflectivité fonction de l'épaisseur de la première couche d'oxyde de la couche de passivation par rapport à l'épaisseur de la seconde couche de nitrure de la couche de passivation,
- la figure 3 représente de manière simplifiée une coupe verticale d'une cellule à photodiode pour laquelle uniquement la couche de passivation est réalisée au-dessus de la région photosensible du substrat semi-conducteur,
- les figures 4a et 4b représentent de manière simplifiée une coupe verticale de la cellule à photodiode avec deux épaisseurs de la couche de diélectrique sur des première et seconde portions de la région photosensible selon l'invention, ainsi qu'une vue de dessus de la cellule montrant les deux portions sur la région photosensible,
- la figure 5 représente de manière simplifiée une vue de dessus de la cellule à photodiode avec plusieurs premières portions de la couche de diélectrique d'épaisseur différente de plusieurs secondes portions sur la région photosensible, et
- la figure 6 représente de manière simplifiée une coupe verticale de la cellule à photodiode pour laquelle la couche de diélectrique est réalisée avec une gravure graduelle sur la région photosensible.

Dans la description suivante comme différentes étapes de procédé de fabrication de telles cellules à photodiode sont bien connues, elles ne seront pas explicitées en détail. Il ne sera fait référence principalement qu'à la structure d'une cellule à photodiode permettant un contrôle de réflectivité de la lumière à capter. Par simplification, la cellule comprend une seule photodiode, même si généralement elle comprend plutôt un réseau matriciel de photodiodes. La lumière captée par la cellule peut être une lumière cohérente produite par une diode laser non représentée.

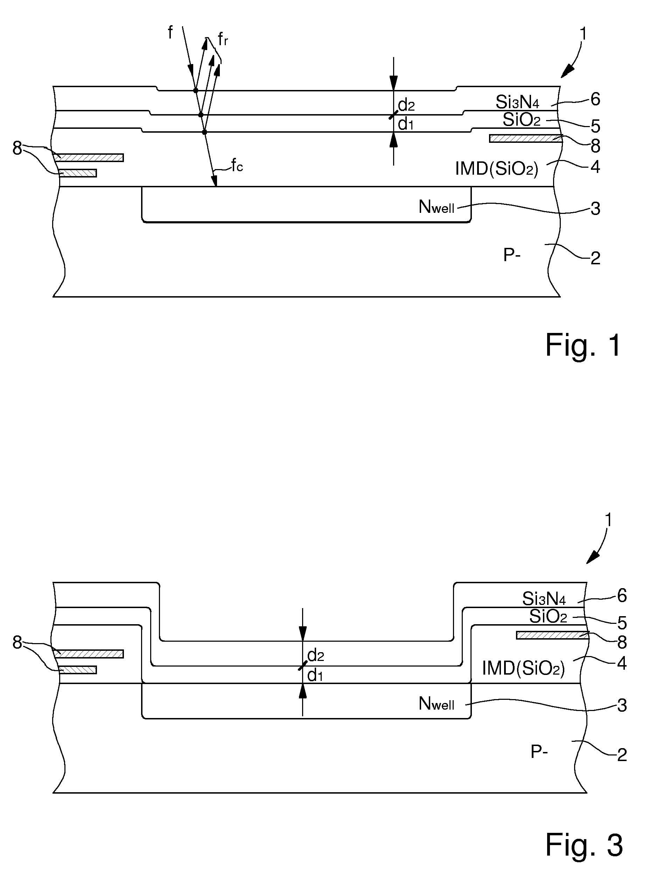

La figure 1 montre une coupe partielle d'une cellule à photodiode 1 composée d'une seule photodiode. Cette cellule à photodiode 1 est réalisée dans un substrat semi-conducteur en silicium 2. Durant le procédé de fabrication, plusieurs cellules à photodiode peuvent être réalisées sur une même plaquette, mais uniquement une cellule à photodiode est expliquée ci-après.

La cellule à photodiode 1 comprend une région photosensible 3, telle qu'une région de caisson Nwell, d'un type de conductivité N, qui est réalisée dans un substrat semi-conducteur en silicium 2 de conductivité de type P-. La région photosensible est en mesure de capter une partie d'un faisceau de lumière f, par exemple un faisceau de lumière cohérente fourni par une diode laser non représentée.

A la surface de la région photosensible 3 et de portions du substrat 2 entourant la région photosensible, une couche de diélectrique IMD (Inter Metal Dielectric en terminologie anglaise) en oxyde de silicium 4 est réalisée. L'épaisseur de cette couche transparente n'est quasiment pas contrôlable, car elle dépend également du nombre de niveaux de métallisation 8 utilisés durant le procédé de fabrication de la cellule. Ce procédé de fabrication peut être un procédé du type TSMC à 0.5 µm ou à 0.18 µm. Entre chaque niveau de métallisation une certaine épaisseur de couche de diélectrique est ainsi réalisée. L'épaisseur de la couche totale de diélectrique peut être de l'ordre de 5 µm.

De manière à protéger les éléments de la cellule à photodiode, une couche de passivation est déposée à la fin des étapes du procédé de fabrication au-dessus de la couche de diélectrique 4. Cette couche de passivation est composée notamment d'une première couche en oxyde de silicium SiO₂ 5 d'épaisseur d1 juste au-dessus de la couche de diélectrique 4, et d'une seconde couche de nitrure Si₃N₄ 6 d'épaisseur d2 au-dessus de la première couche.

Lorsqu'un faisceau de lumière cohérente f doit être capté par la région photosensible 3 de la cellule à photodiode 1, une partie fᵣ du faisceau est réfléchie sur la seconde couche de nitrure 6, sur la couche d'oxyde de silicium 5 et éventuellement sur la couche de diélectrique 4. Cette réflexion est en partie due également aux indices de réfraction différents des couches de protection. Ainsi uniquement un certain pourcentage f_{c} du faisceau de lumière f est capté par la région photosensible 3.

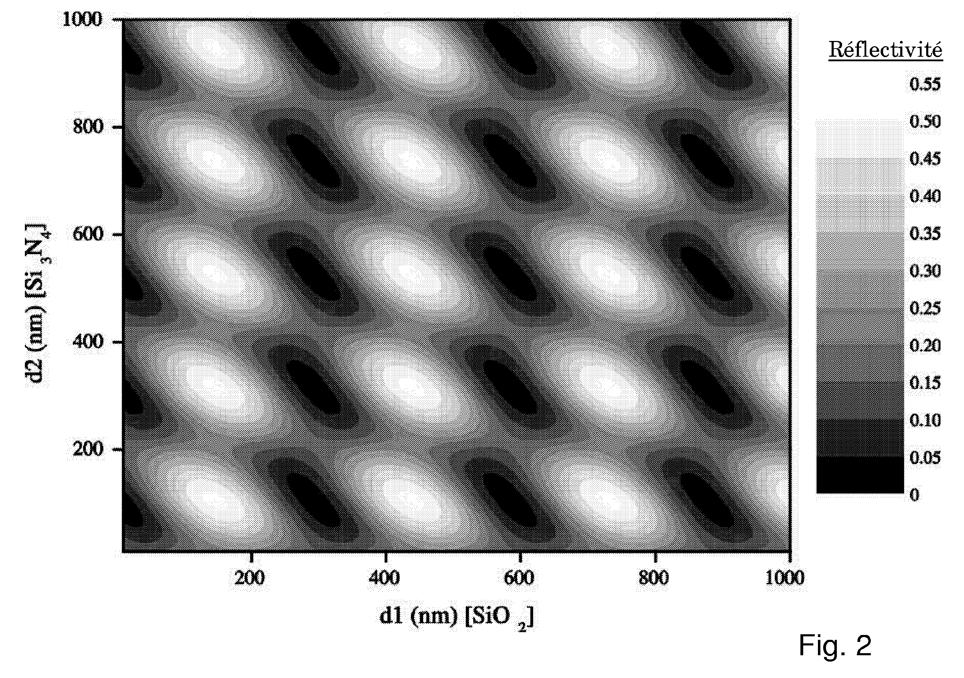

A la figure 2, un graphique représente la réflectivité de lumière de la cellule à photodiode en fonction de l'épaisseur d1 de la première couche d'oxyde de silicium par rapport à l'épaisseur d2 de la seconde couche de nitrure. On remarque sur cette figure 2, qu'en contrôlant l'épaisseur d2 de la seconde couche de nitrure dans une marge déterminée entre deux maxima de réflectivité, il est possible d'obtenir une réflectivité sensiblement constante. Cette réflectivité constante est indépendante de l'épaisseur de la première couche d'oxyde et également indépendante de l'épaisseur de la couche de diélectrique.

L'épaisseur de cette seconde couche de nitrure doit être contrôlée durant le procédé de fabrication pour chaque plaquette de cellules à photodiode, et également pour chaque lot de plaquettes, car certaines différences entre plaquettes ou entre lots peuvent être constatées durant un même procédé de fabrication. Pour une longueur d'onde de la lumière cohérente de l'ordre de 850 nm, l'épaisseur d2 de la seconde couche de nitrure peut valoir M fois 210 nm, où M est un nombre entier supérieur ou égal à 1. Par le contrôle de cette couche de nitrure selon l'invention, il est possible d'obtenir une cellule à photodiode dont le pourcentage de réflectivité de la lumière est proche de 25% par rapport à un maximum qui peut être de 50% par exemple. Ceci correspond à une réflectivité de 0.25 par rapport à un maximum de 0.5 sur une échelle de 0 à 1 comme montré en figure 2.

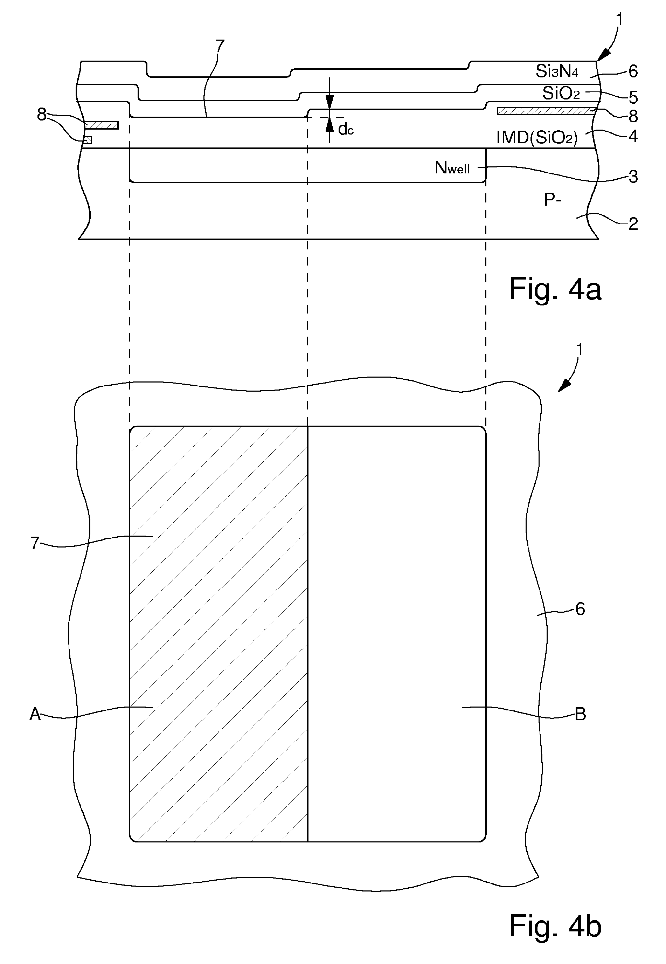

Dans le cas où la couche de diélectrique peut être entièrement retirée sur la surface de la région photosensible comme montré à la figure 3, il peut être envisagé également de contrôler l'épaisseur d1 de la première couche d'oxyde de silicium. En choisissant une épaisseur d2 de la seconde couche de nitrure comme indiqué ci-dessus, il est possible d'abaisser le pourcentage de réflectivité entre 25% et 20% en contrôlant également l'épaisseur d1 de la première couche.

Bien entendu s'il était possible de retirer la couche de diélectrique avant le dépôt de la couche de passivation, il aurait pu être réalisé une cellule à photodiode pour laquelle le pourcentage de réflectivité serait proche de 0%. Pour ce faire avec une longueur d'onde de la lumière de l'ordre de 850 nm, l'épaisseur d1 de la première couche d'oxyde de silicium pourrait être contrôlée à une valeur de N fois 290 nm, où N est un nombre entier supérieur ou égal à 1. Dans ce cas, l'épaisseur d2 de la couche de nitrure devrait être par exemple de l'ordre de 105 nm, 315 nm, 525 nm ou 735 nm.

En plus de contrôler l'épaisseur d2 de la couche de nitrure, il peut être également réalisé une gravure 7 par attaque chimique à une première épaisseur d'une portion A de la couche de diélectrique 4 sur la région photosensible comme montré aux figures 4a et 4b. Ainsi, un écart d'épaisseur de est réalisé entre la couche de diélectrique 4 gravée sur la portion A et la couche de diélectrique non gravée sur une portion B à une seconde épaisseur sur la région photosensible. Cet écart d'épaisseur est déterminé en fonction de l'écart d'épaisseur de la première couche en oxyde de silicium 5 entre un pourcentage minimal et maximal de réflectivité de lumière. Pour une longueur d'onde de la lumière de l'ordre de 850 nm, cet écart d'épaisseur d_{c} peut être de l'ordre de 145 nm.

La dimension des portions A et B correspond approximativement à la surface de réception de la région photosensible 3. La surface de réception peut être de 28 µm sur 28 µm. De préférence, la dimension de la première portion A de réception de lumière de la région photosensible 3 est sensiblement égale à la dimension de la seconde portion B de réception de lumière de la région photosensible. De cette façon indépendamment des fluctuations d'épaisseurs de la couche de diélectrique et de la couche d'oxyde de silicium, une moyenne du pourcentage de réflectivité de lumière des deux portions peut être obtenue. Une des deux portions A et B de réception de lumière de la région photosensible 3 est ainsi plus sensible que l'autre portion.

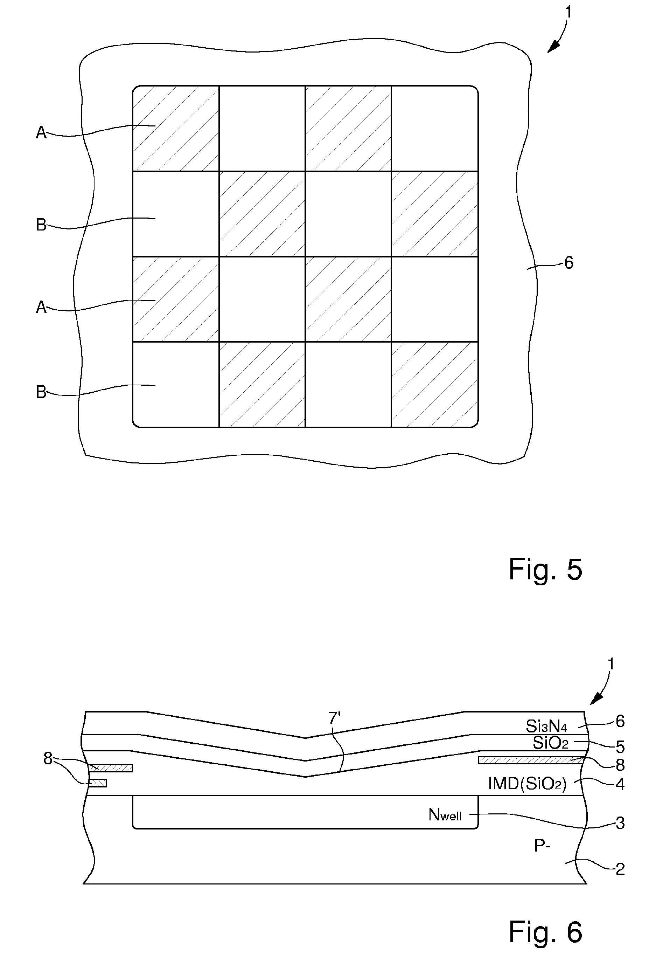

Comme montré de manière simplifiée à la figure 5, il peut être prévu plusieurs premières portions A de la couche de diélectrique à une première épaisseur, et plusieurs secondes portions B de la couche de diélectrique à une seconde épaisseur. Ces premières et secondes portions A et B sont réparties alternativement sur la région photosensible sous forme de mosaïque. La mosaïque peut représenter un damier, mais également un agencement de portions de forme triangulaire vues de dessus. Avec cette répartition des premières et secondes portions des couches d'épaisseurs différentes, une meilleure moyenne du pourcentage de réflectivité de lumière peut être obtenue.

Il est à noter qu'il est également possible de graver la première couche d'oxyde de silicium au lieu de graver la couche de diélectrique pour obtenir des couches d'épaisseurs différentes. De plus au lieu d'une opération de gravure, il peut être imaginé de réaliser un dépôt supplémentaire de la couche de diélectrique 4 ou de la première couche sur au moins une portion de la région photosensible.

La figure 6 montre une vue en coupe d'une autre forme de réalisation de la cellule à photodiode 1. La couche de diélectrique 4 peut être gravée par une attaque chimique graduelle au-dessus de la surface de réception de la région photosensible 3. La couche de diélectrique 4 gravée présente une épaisseur variable sur la région photosensible 3. L'épaisseur peut être maximale à proximité du bord de la région photosensible et minimale à proximité du centre de la région photosensible.

Bien entendu, au lieu de graver la couche de diélectrique, il peut aussi être imaginé de graver la première couche d'oxyde de silicium de la couche de passivation.

Il est encore à noter que la conductivité du substrat semi-conducteur de la cellule à photodiode peut également être de type N- dans lequel est réalisé un caisson de type P pouvant servir de région photosensible. Cependant, la région photosensible en N+ peut aussi être réalisée dans la région de caisson de type P. D'autres possibilités sont envisageables.

A partir de la description qui vient d'être faite, de multiples variantes de réalisation de la cellule à photodiode et du procédé de fabrication de ladite cellule peuvent être conçues par l'homme du métier sans sortir du cadre de l'invention définie par les revendications. La couche de passivation peut comprendre également une couche en SiON.

## Revendications

1. Cellule à photodiode (1) comprenant au moins une région photosensible (3), réalisée dans un substrat semi-conducteur en silicium (2), pour la réception de la lumière, notamment de la lumière cohérente, et une couche de passivation, qui est composée au moins d'une première couche d'oxyde de silicium (5) et d'une seconde couche de nitrure (6), réalisée sur la région photosensible, **caractérisée en ce que** la seconde couche de nitrure est réalisée avec une épaisseur dans une marge déterminée de manière à se situer dans une zone à réflectivité de lumière la plus constante possible indépendamment de l'épaisseur de la première couche.

2. Cellule à photodiode (1) selon la revendication 1, **caractérisée en ce qu'**au moins une couche de diélectrique en oxyde de silicium (4) est réalisée entre la région photosensible (3) et la première couche (5) de la couche de passivation, et **en ce que** la couche de diélectrique ou la première couche de la couche de passivation est réalisée avec au moins une première épaisseur sur une première portion (A) de la région photosensible et avec au moins une seconde épaisseur différente de la première épaisseur sur une seconde portion (B) de la région photosensible.

3. Cellule à photodiode (1) selon la revendication 2, **caractérisée en ce que** l'écart d'épaisseur de la couche de diélectrique ou de la première couche sur les deux portions (A, B) de la région photosensible est déterminée en fonction de l'écart d'épaisseur de la première couche en oxyde de silicium entre un pourcentage minimal et maximal de réflectivité de lumière.

4. Cellule à photodiode (1) selon la revendication 2, **caractérisée en ce que** l'écart d'épaisseur de la couche de diélectrique ou de la première couche est obtenu par gravure (7) d'une portion de la couche de diélectrique ou de la première couche en oxyde de silicium, ou par un dépôt supplémentaire de la couche de diélectrique ou de la première couche, et **en ce que** la dimension de la première portion (A) de réception de lumière de la région photosensible (3) est sensiblement égale à la dimension de la seconde portion (B) de réception de lumière de la région photosensible.

5. Cellule à photodiode (1) selon l'une des revendications 2 et 3, **caractérisée en ce que** plusieurs premières portions (A) de la couche de diélectrique ou de la première couche ont une première épaisseur, et **en ce que** plusieurs secondes portions (B) de la couche de diélectrique ou de la première couche ont une seconde épaisseur de manière à être réparties sur la région photosensible sous forme de mosaïque, et **en ce que** la dimension de toutes les premières portions (A) est sensiblement égale à la dimension de toutes les secondes portions (B).

6. Cellule à photodiode (1) selon la revendication 1, **caractérisée en ce qu'**une couche de diélectrique (4) entre la région photosensible (3) et la première couche de la couche de passivation, ou la première couche (5) de la couche de passivation est réalisée avec une épaisseur variable (7') obtenue par une attaque chimique graduelle pour présenter une épaisseur maximale à proximité du bord de la région photosensible et une épaisseur minimale à proximité du centre de la région photosensible.

7. Cellule à photodiode (1) selon la revendication 1, **caractérisée en ce que** la première couche d'oxyde de silicium (5) de la couche de passivation est en contact direct avec la surface de la région photosensible (3), et **en ce que** la première couche est réalisée à une épaisseur déterminée de manière à obtenir un pourcentage minimal de réflectivité de lumière.

8. Cellule à photodiode (1) selon la revendication 1, susceptible de capter de la lumière cohérente d'une source laser à longueur d'onde voisine de 850 nm, **caractérisée en ce que** l'épaisseur de la seconde couche de nitrure (6) peut être réalisée à une valeur voisine de M fois 210 nm, où M est un nombre entier supérieur ou égal à 1.

9. Procédé de fabrication d'une cellule à photodiode (1) selon l'une des revendications précédentes, **caractérisé en ce qu'**au moins une première couche d'oxyde de silicium (5) d'une couche de passivation est réalisée sur une région photosensible (3) du substrat susceptible de capter de la lumière, et **en ce qu'**une seconde couche de nitrure (6) de la couche de passivation est réalisée sur la première couche avec une épaisseur dans une marge déterminée de manière à se situer dans une zone à réflectivité de lumière la plus constante possible indépendamment de l'épaisseur de la première couche.

10. Procédé de fabrication selon la revendication 9, **caractérisé en ce qu'**une couche de diélectrique en oxyde de silicium (4) est réalisée au-dessus de la région photosensible (3) avant la réalisation de la première couche (5), **en ce que** la couche de diélectrique ou la première couche est gravée par attaque chimique sur au moins une première portion (A) de la région photosensible pour que la différence d'épaisseur entre la couche gravée au-dessus de la première portion et la couche de diélectrique ou la première couche au-dessus d'une seconde portion (B) de la région photosensible soit fonction de l'écart d'épaisseur de la première couche d'oxyde de silicium relatif à un pourcentage minimal et maximal de réflectivité de lumière, et **en ce que** la dimension de la première portion de réception de lumière de la région photosensible (3) est sensiblement égale de la dimension de la seconde portion de réception de lumière de la région photosensible.
